# EUROPÄISCHE PATENTANMELDUNG

(11) **EP 3 751 605 A1**
(43) Veröffentlichungstag der Anmeldung: **16.12.2020**
(21) Anmeldenummer: 19179441.1
(22) Anmeldetag: 11.06.2019
(51) Int. Cl.: H01L 23/498, H01L 23/538, H01L 25/07, H05K 1/02, H05K 1/11

(54) **ELEKTRONISCHER SCHALTKREIS UND VERFAHREN ZUR HERSTELLUNG EINES ELEKTRONISCHEN SCHALTKREISES**

(71) Anmelder: Siemens Aktiengesellschaft, 80333 München (DE)
(72) Erfinder: Bigl, Thomas, 91074 Herzogenaurach (DE); Hensler, Alexander, 90766 Fürth (DE); Neugebauer, Stephan, 91058 Erlangen (DE); Pfefferlein, Stefan, 90562 Heroldsberg (DE)

(57) **Zusammenfassung**

Zur Leistungsverbesserung wird ein elektronischer Schaltkreis (7) mit einem ersten und einem zweiten Schaltungsträger (6, 8) sowie einem ersten und einem zweiten Halbleiterbauelement (9, 10) angegeben. Das erste Halbleiterbauelement (9) liegt mit einer Oberseite an einer Unterseite des ersten Schaltungsträgers (6) an sowie mit einer Unterseite an einer Oberseite des zweiten Schaltungsträgers (8). Der erste Schaltungsträger (6) weist eine erste Durchkontaktierung (11) auf, welche das erste Halbleiterbauelement (9) mit einer ersten Leiterbahn verbindet. Der erste Schaltungsträger (6) weist eine zweite Durchkontaktierung (13) auf, welche ein zwischen den Schaltungsträgern angeordnetes Verbindungselement (14) mit einer weiteren Leiterbahn elektrisch verbindet. Über das erste Verbindungselement (14) wird stellt eine stoffschlüssige Verbindung zwischen den Schaltungsträgern hergestellt. Das zweite Halbleiterbauelement (10) liegt an der Unterseite des ersten Schaltungsträgers (6) an und ist elektrisch mit der ersten oder zweiten Leiterbahn verbunden.

## Beschreibung

Die vorliegende Erfindung betrifft einen elektronischen Schaltkreis aufweisend einen ersten Schaltungsträger und einen zweiten Schaltungsträger sowie ein leistungselektronisches erstes Halbleiterbauelement mit einer Oberseite, die an einer Unterseite des ersten Schaltungsträgers anliegt, sowie einer Unterseite, die an einer Oberseite des zweiten Schaltungsträgers anliegt. Der Schaltkreis weist auch ein zweites Halbleiterbauelement auf. Die Erfindung betrifft ferner ein entsprechendes Verfahren zur Herstellung eines elektronischen Schaltkreises.

Im Bereich der Leistungselektronik liegen Halbleiterbauelemente, beispielsweise Schaltelemente, in der Regel in Form von Leistungsmodulen, auch als Powermodule bezeichnet, oder in Form von diskreten Packages vor. Die Halbleiterbauelemente sind dabei mittels spezifischer Drahtbondtechnologien kontaktiert und die Leistungsmodule werden zum Beispiel mittels Löt-, Feder- oder Pressverbindungen an einem Schaltungsträger befestigt.

Durch die Verwendung der Bonddrähte wird die maximal zulässige Stromdichte durch die Halbleiterbauelemente limitiert. Außerdem kommt es zu parasitären Induktivitäten, welche eine erzielbare Schaltgeschwindigkeit der Schaltelemente begrenzt.

Vor diesem Hintergrund ist es eine Aufgabe der vorliegenden Erfindung, ein verbessertes Konzept für einen elektronischen Schaltkreis mit wenigstens einem leistungselektronischen Halbleiterbauelement anzugeben, durch welches das Schaltverhalten des Schaltkreises verbessert wird, um eine maximal erzielbare Stromdichte sowie eine Schaltgeschwindigkeit zu erhöhen werden.

Gemäß dem verbesserten Konzept wird diese Aufgabe durch einen elektronischen Schaltkreis sowie ein Verfahren zum Herstellen eines elektronischen Schaltkreises nach den unabhängigen Patentansprüchen gelöst. Vorteilhafte Weiterbildungen und weitere Ausführungsformen sind Gegenstand der abhängigen Ansprüche.

Gemäß einem ersten unabhängigen Aspekt des verbesserten Konzepts wird ein elektronischer Schaltkreis angegeben, der einen ersten Schaltungsträger, einen zweiten Schaltungsträger, ein erstes leistungselektronisches Halbleiterbauelement sowie ein zweites Halbleiterbauelement aufweist. Das erste Halbleiterbauelement weist eine Oberseite auf, die an einer Unterseite des ersten Schaltungsträgers anliegt, sowie eine Unterseite, die an einer Oberseite des zweiten Schaltungsträgers anliegt. Der erste Schaltungsträger weist eine erste Durchkontaktierung auf, welche die Oberseite des ersten Halbleiterbauelements elektrisch mit einer ersten Leiterbahn des ersten Schaltungsträgers verbindet. Der erste Schaltungsträger weist eine zweite Durchkontaktierung auf, welche ein zwischen der Unterseite des ersten Schaltungsträgers und der Oberseite des zweiten Schaltungsträgers angeordnetes erstes Verbindungselement mit einer zweiten Leiterbahn des ersten Schaltungsträgers elektrisch verbindet. Das erste Verbindungselement stellt eine stoffschlüssige, insbesondere elektrische, Verbindung zwischen der Oberseite des zweiten Schaltungsträgers und der Unterseite des ersten Schaltungsträgers her oder über das erste Verbindungselement wird eine stoffschlüssige, insbesondere elektrische, Verbindung zwischen der Oberseite des zweiten Schaltungsträgers und der Unterseite des ersten Schaltungsträgers hergestellt. Eine Oberseite des zweiten Halbleiterbauelements liegt an der Unterseite des ersten Schaltungsträgers an und ist elektrisch mit der ersten oder der zweiten Leiterbahn verbunden.

Die Oberseiten der Schaltungsträger beziehungsweise der Halbleiterbauelemente liegen den jeweiligen Unterseiten der Schaltungsträger beziehungsweise der Halbleiterbauelemente gegenüber. Darüber hinaus stellen die Bezeichnung "Oberseite" und "Unterseite" jeweils keine Einschränkung bezüglich einer etwaigen räumlichen Ausrichtung der entsprechenden Komponenten dar. Die Begrifflichkeiten wurden beispielhaft gewählt und sind angelehnt an eine Anordnung, bei der von oben nach unten zunächst der erste Schaltungsträger, dann die Halbleiterbauelemente und dann der zweite Schaltungsträger angeordnet sind.

Dass eine Seite eines Halbleiterbauelements an einer Seite eines Schaltungsträgers anliegt, kann insbesondere derart verstanden werden, dass die entsprechende Seite des Halbleiterbauelements in einem Kontaktbereich der entsprechenden Seite des Schaltungsträgers planparallel oder im Wesentlichen planparallel zu dieser ausgerichtet ist und flächig an dieser anliegt. Zwischen der jeweiligen Seite des Halbleiterbauelements und der jeweiligen Seite des Schaltungsträgers kann sich ein flächiges Verbindungsmaterial, beispielsweise ein Klebstoff, ein Lot- oder Sintermaterial, befinden, oder die beiden Seiten sind direkt, beispielsweise eutektisch, miteinander verbunden. Insbesondere befindet sich kein Bonddraht zwischen dem jeweiligen Halbleiterbauelement und dem zugehörigen Schaltungsträger.

Die Halbleiterbauelemente können mit dem ersten Schaltungsträger, insbesondere mittels Chipbonden, welches auch als Die-Bonden bezeichnet werden kann, verbunden sein. Das Chipbonden ist insbesondere im Gegensatz zum Drahtbonden zu verstehen und kann beispielsweise eine Verbindung mittels einer Löt- oder Sinterverbindung, einer Klebverbindung und/oder einer eutektischen Verbindung erfolgen. Die eutektische Verbindung kann beispielsweise auch als eutektisches Löten oder Anlegieren bezeichnet werden. Entsprechendes gilt auch für die Verbindung des ersten Halbleiterbauelements mit dem zweiten Schaltungsträger und, falls zutreffend, des zweiten Halbleiterbauelements mit einem dritten Schaltungsträger.

Dass es sich bei dem ersten Halbleiterbauelement um ein leistungselektronisches Halbleiterbauelement handelt, kann beispielsweise derart verstanden werden, dass es sich dabei um ein solches Halbleiterbauelement handelt, welches zur Verwendung in leistungselektronischen Anwendungen, also insbesondere in Anwendungen zur Umformung elektrischer Energie mit schaltenden elektronischen Bauelementen, eignet.

Beispielsweise kann es sich bei dem zweiten Halbleiterbauelement ebenfalls um ein leistungselektronisches Halbleiterbauelement handeln.

Beispiele für leistungselektronische Halbleiterbauelemente sind Diacs, Triacs, Leistungstransistoren, insbesondere bipolare Leistungstransistoren, Leistungs-MOSFETs oder IGBTs, Thyristoren, beispielsweise GTO-Thyristoren, Leistungsdioden oder Leistungskondensatoren.

Bei dem ersten Schaltungsträger kann es sich insbesondere um einen mehrlagigen Schaltungsträger, also insbesondere einen Schaltungsträger mit zwei, drei oder mehr elektrisch leitfähigen Lagen, handeln. Die erste und die zweite Leiterbahn sind in dem ersten Schaltungsträger insbesondere galvanisch voneinander getrennt. Dies bedeutet, dass bei alleiniger Betrachtung des ersten Schaltungsträgers, also insbesondere ohne montierte Bauelemente, die erste und die zweiten Leiterbahn galvanisch voneinander getrennt sind. Dabei können die erste und die zweite Leiterbahn Teile derselben elektrisch leitfähigen Lage sein oder jeweils Teile unterschiedlicher elektrisch leitfähiger Lagen.

Bei dem ersten Verbindungselement handelt es sich insbesondere um einen elektrisch leitfähigen Verbindungskörper, beispielsweise einen Verbindungskörper für eine Löt- oder Sinterverbindung. Der Verbindungskörper besteht dabei beispielsweise aus einem Lotmaterial oder einem Sintermaterial. Insbesondere beinhaltet das erste Verbindungselement keinen Bonddraht.

Durch die Kombination wenigstens zweier Schaltungsträger mit mindestens zwei Halbleiterbauelementen in der beschriebenen Weise kann eine gehäuste Modulbauweise in leistungselektronischen Schaltkreisen vermieden werden.

Ein Powermodul beinhaltet in der Regel einen Schaltungsträger und mehrere Leistungshalbleiter, die auf dem Schaltungsträger angeordnet sind. Die einzelnen Leistungshalbleiter sind untereinander auch mittels Bonddrähten elektrisch verbunden. Der Schaltungsträger sowie die Leistungshalbleiter befinden sich in einem abgeschlossenen Gehäuse, welches über Kontaktierungselemente an einen weiteren Schaltungsträger oder an eine Stromschiene gekoppelt werden kann.

Gemäß dem verbesserten Konzept werden insbesondere solche Bonddrahtverbindungen und auch die separaten Kontaktierungselemente zwischen dem Gehäuse des Powermoduls und dem weiteren Schaltungsträger vermieden.

Dadurch werden parasitäre Induktivitäten durch die Bonddrähte vermieden, und das Leistungspotential, insbesondere die elektrische Belastbarkeit und die Schaltgeschwindigkeit, der zur Verfügung stehenden Halbleiterbauelemente kann voll ausgenutzt werden. Insbesondere wird eine maximal einsetzbare Stromdichte nicht mehr durch einen relativ geringen Leitungsquerschnitt von Bonddrähten limitiert. Auch die Limitierung der Schaltzeiten durch parasitäre Induktivitäten wird dadurch verhindert.

Die höhere Stromtragfähigkeit wird insbesondere durch die direkte und flächige Anbindung der Chipflächen an die Schaltungsträger ermöglicht. Aus demselben Grund ergeben sich auch eine bessere thermische Anbindung und eine entsprechende verbesserte Wärmeabfuhr.

Durch die Anordnung nach dem verbesserten Konzept kann zudem ein besonders kompakter Aufbau und damit eine bessere Integration des elektronischen Schaltkreises, insbesondere ein geringerer Platzbedarf, erzielt werden.

Gemäß zumindest einer Ausführungsform handelt es sich bei dem elektronischen Schaltkreis um einen leistungselektronischen Schaltkreis, also um einen elektronischen Schaltkreis zur Anwendung im Bereich der Leistungselektronik.

Gemäß zumindest einer Ausführungsform liegen das erste und das zweite Halbleiterbauelement auf separaten Halbleiterchips vor.

Gemäß zumindest einer Ausführungsform überdeckt der erste Schaltungsträger das erste und das zweite Halbleiterbauelement vollständig sowie den zweiten Schaltungsträger vollständig. Mit anderen Worten ist eine laterale Ausdehnung des zweiten Schaltungsträgers größer als eine laterale Ausdehnung des ersten Halbleiterbauelements und kleiner als eine laterale Ausdehnung des ersten Schaltungsträgers.

Als lateral werden hier und im Folgenden Raumrichtungen bezeichnet, die parallel zu Schichtebenen der Halbleiterbauelemente und der Schaltungsträger sind.

Gemäß zumindest einer Ausführungsform überdeckt der zweite Schaltungsträger das erste Halbleiterbauelement vollständig.

Gemäß zumindest einer Ausführungsform ist die Unterseite des ersten Halbleiterbauelements elektrisch mit der Oberseite des zweiten Schaltungsträgers verbunden.

Gemäß zumindest einer Ausführungsform stellt das erste Verbindungselement eine elektrische Verbindung zwischen der Oberseite des zweiten Schaltungsträgers und der Unterseite des ersten Schaltungsträgers her.

Gemäß zumindest einer Ausführungsform beinhaltet der erste Schaltungsträger eine mehrlagige Leiterplatte. Als Leiterplatte kann dabei ein Aufbau aus einem oder mehreren Prepregs, einem oder mehreren Kernen und einer oder mehreren Leitungslagen oder -schichten, beispielsweise Kupferschichten, verstanden werden. Insbesondere kann es sich bei der Leiterplatte um eine FR2-, FR3-, FR4- oder FR5-basierte Leiterplatte oder um eine CEM1- oder CEM3-basierte Leiterplatte handeln. Insbesondere beinhaltet die Leiterplatte beziehungsweise der erste Schaltungsträger keine flexible Leiterplatte, Flex-Leiterplatte, starrflexible Leiterplatte oder semiflexible Leiterplatte, insbesondere im Überlappungsbereich mit dem zweiten Schaltungsträger.

Gemäß zumindest einer Ausführungsform weist der erste Schaltungsträger eine dritte Durchkontaktierung auf, welche die Oberseite des zweiten Halbleiterbauelements elektrisch mit der zweiten Leiterbahn verbindet.

Gemäß zumindest einer Ausführungsform weist der elektronische Schaltkreis einen dritten Schaltungsträger auf. Eine Unterseite des zweiten Halbleiterbauelements liegt an einer Oberseite des dritten Schaltungsträgers an. Insbesondere ist die Unterseite des zweiten Halbleiterbauelements mit der Oberseite des dritten Schaltungsträgers elektrisch verbunden.

Die obigen Ausführungen sowie gegebenenfalls weitere Ausführungen zu dem zweiten Schaltungsträger gelten analog für den dritten Schaltungsträger.

Gemäß zumindest einer Ausführungsform sind der zweite und der dritte Schaltungsträger in einer Ebene angeordnet, weisen also insbesondere denselben Abstand zum ersten Schaltungsträger auf.

Gemäß zumindest einer Ausführungsform weist der erste Schaltungsträger eine vierte Durchkontaktierung auf, welche ein zwischen der Unterseite des ersten Schaltungsträgers und der Oberseite des dritten Schaltungsträgers angeordnetes zweites Verbindungselement mit der ersten Leiterbahn oder mit einer dritten Leiterbahn des ersten Schaltungsträgers elektrisch verbindet. Über das zweite Verbindungselement wird eine stoffschlüssige, insbesondere elektrische, Verbindung zwischen der Oberseite des dritten Schaltungsträgers und der Unterseite des ersten Schaltungsträgers hergestellt.

Die obigen Ausführungen zum ersten Verbindungselement gelten analog für das zweite Verbindungselement.

Gemäß zumindest einer Ausführungsform ist die Unterseite des zweiten Halbleiterbauelements mit der Oberseite des dritten Schaltungsträgers elektrisch verbunden.

Gemäß zumindest einer Ausführungsform weist der Schaltkreis einen Kühlkörper auf, auf dem der zweite Schaltungsträger angeordnet ist.

Gemäß zumindest einer Ausführungsform ist der dritte Schaltungsträger auf dem Kühlkörper angeordnet.

Der zweite und gegebenenfalls der dritte Schaltungsträger sind insbesondere an dem Kühlkörper befestigt und insbesondere direkt mit dem Kühlkörper verbunden. Die direkte Verbindung schließt dabei Fälle ein, in denen sich ein Verbindungsmaterial, beispielsweise ein Klebstoff, ein Löt- oder Sintermaterial, und/oder ein Medium zur verbesserten Wärmleitfähigkeit, beispielsweise eine Wärmeleitpaste, zwischen dem jeweiligen Schaltungsträger und dem Kühlkörper befindet.

In solchen Ausführungsformen wird ein gemeinsamer Kühlkörper für beide Halbleiterbauelemente sowie für den zweiten und den dritten Schaltungsträger genutzt. Der gemeinsame Kühlkörper kann auch zur Wärmeabfuhr für weitere Schaltungsträger und/oder Halbleiterbauelemente des Schaltkreises genutzt werden.

Gemäß zumindest einer Ausführungsform weist der Schaltkreis eine Klemmvorrichtung auf, um den zweiten Schaltungsträger, und falls zutreffend den dritten Schaltungsträger, über eine Krafteinwirkung auf den ersten Schaltungsträger auf den Kühlkörper zu pressen.

Dadurch werden ein verbesserter mechanischer und damit auch ein verbesserter thermischer Kontakt zwischen dem Kühlkörper und dem zweiten Schaltungsträger beziehungsweise zwischen dem Kühlkörper und dem dritten Schaltungsträger und somit zwischen dem Kühlkörper und den Halbleiterbauelementen ermöglicht.

Der bessere thermische Kontakt führt zu einer verbesserten Wärmeabfuhr. Der verbesserte mechanische Kontakt führt außerdem auch zu einer verbesserten Zuverlässigkeit des elektrischen Schaltkreises, da im Betrieb auftretende mechanische Bewegungen oder Spannungen besser kompensiert werden können.

Gemäß zumindest einer Ausführungsform beinhaltet die Klemmvorrichtung ein Klemmelement, beispielsweise eine Klemmplatte, welches auf einer dem ersten und dem zweiten Halbleiterbauelement abgewandten Oberseite des ersten Schaltungsträgers angeordnet ist und beispielsweise auf diesem aufliegt. Das Klemmelement ist mechanisch mit dem Kühlkörper verbunden.

Gemäß zumindest einer Ausführungsform ist das Klemmelement als Platte ausgebildet, die auf der Oberseite des ersten Schaltungsträgers aufliegt.

Gemäß zumindest einer Ausführungsform weist der Kühlkörper wenigstens ein Gewinde, beispielsweise ein Innengewinde, oder eine Hinterschneidung auf. Die Klemmvorrichtung weist wenigstens eine Schraube und/oder wenigstens ein Spreizelement auf. Der erste Schaltungsträger weist wenigstens eine Durchgangsöffnung auf.

Beispielsweise kann die Klemmvorrichtung die wenigstens eine Schraube aufweisen und das Klemmelement weist ebenfalls wenigstens eine Durchgangsöffnung auf. Die wenigstens eine Schraube ist durch die wenigstens eine Durchgangsöffnung des Klemmelements geführt.

Beispielsweise kann die Klemmvorrichtung das wenigstens eine Spreizelement aufweisen und das wenigstens eine Spreizelement ist mit dem Klemmelement verbunden.

Die wenigstens eine Schraube oder das wenigstens eine Spreizelement wird durch die wenigstens eine Durchgangsöffnung des ersten Schaltungsträgers geführt und mittels des wenigstens einen Gewindes des Kühlkörpers mechanisch mit diesem verbunden.

Durch die Klemmvorrichtung kann das Klemmelement mittels der Schrauben oder Spreizelemente eine Kraft auf den ersten Schaltungsträger und damit auf die Halbleiterbauelemente ausüben, so dass die Halbleiterbauelemente und der zweite sowie gegebenenfalls der dritte Schaltungsträger auf den Kühlkörper gepresst werden.

Gemäß zumindest einer Ausführungsform ist das erste Halbleiterbauelement als leistungselektronisches Schaltelement ausgestaltet.

Gemäß zumindest einer Ausführungsform ist das zweite Halbleiterbauelement als leistungselektronisches Schaltelement ausgestaltet.

Das leistungselektronische Schaltelement kann beispielsweise einen Leistungstransistor, beispielsweise einen Wide-Bandgap-Transistor, einen IGBT, einen bipolaren Leistungstransistor oder einen Leistungs-MOSFET beinhalten.

Bei dem Wide-Bandgap-Leistungstransistor handelt es sich insbesondere um einen Leistungstransistor auf Basis von Galliumnitrid oder Siliziumkarbid.

Gemäß zumindest einer Ausführungsform sind das erste und das zweite Halbleiterbauelement mittels des ersten Schaltungsträgers, insbesondere mittels der ersten und der zweiten Leiterbahn und gegebenenfalls mittels der dritten Leiterbahn, zu einer Halbbrückenschaltung oder zu einem Teil einer sonstigen Brückenschaltung, beispielsweise einer Vollbrückenschaltung, verschaltet.

Die Halbbrückenschaltung weist insbesondere einen ersten und einen zweiten Gleichspannungsanschluss sowie einen Wechselspannungsanschluss auf. Die erste Leiterbahn ist beispielsweise elektrisch mit dem ersten Gleichspannungsanschluss verbunden. Die zweite Leiterbahn ist beispielsweise elektrisch mit dem Wechselspannungsanschluss verbunden. Die dritte Leiterbahn ist beispielsweise elektrisch mit dem zweiten Gleichspannungsanschluss verbunden.

Gemäß zumindest einer Ausführungsform weist der zweite Schaltungsträger eine die Oberseite des zweiten Schaltungsträgers bildende erste elektrisch leitfähige Schicht, insbesondere Metallschicht, auf. Der zweite Schaltungsträger weist außerdem eine auf einer dem ersten Schaltungsträger abgewandten Seite der ersten elektrisch leitfähigen Schicht angeordnete elektrisch isolierende Schicht, insbesondere Keramikschicht oder Keramikkörper, auf.

Insbesondere kann der dritte Schaltungsträger identisch oder analog zum zweiten Schaltungsträger ausgestaltet sein.

Durch die Verwendung der elektrisch isolierenden Schicht wird die elektrische Isolierung der Halbleiterbauelemente zu dem Kühlkörper realisiert. Durch die Verwendung einer Keramikschicht kann gleichzeitig eine gute Wärmeleitung sichergestellt werden. Eine solche Anordnung zeichnet sich auch durch eine gute Beständigkeit gegenüber Temperaturzyklen aus. Gemäß zumindest einer Ausführungsform beinhaltet die Keramikschicht Aluminiumoxid, Aluminiumnitrid oder Siliziumnitrid oder besteht aus einer der genannten Verbindungen.

Gemäß zumindest einer Ausführungsform weist der zweite Schaltungsträger eine auf einer der ersten elektrisch leitfähigen Schicht abgewandten Seite der elektrisch isolierenden Schicht angeordnete zweite elektrisch leitfähige Schicht, insbesondere Metallschicht, auf.

Durch die Anordnung "leitfähige Schicht - isolierende Schicht - leitfähige Schicht" kann insbesondere eine erhöhte Robustheit gegenüber thermischen Verformungen des zweiten Schaltungsträgers erzielt werden. Dies gilt insbesondere dann, wenn die erste und die zweite elektrisch leitfähige Schicht aus demselben Material hergestellt sind und die zweite elektrisch leitfähige Schicht ein größeres oder zumindest gleich großes Volumen wie die erste elektrisch leitfähige Schicht aufweist.

Beispielsweise kann der zweite Schaltungsträger als DBC- oder DCB-Substrat ausgebildet sein. DBC steht dabei für "direct bonded copper", DCB für "direct copper bonded".

Gemäß zumindest einer Ausführungsform bestehen die erste und/oder die zweite elektrisch leitfähige Schicht aus Kupfer oder einer Kupferlegierung.

Gemäß zumindest einer Ausführungsform ist ein lateraler Wärmeausdehnungskoeffizient des ersten Schaltungsträgers größer oder gleich einem lateralen Wärmeausdehnungskoeffizienten des zweiten Schaltungsträgers und gegebenenfalls größer oder gleich einem lateralen Wärmeausdehnungskoeffizienten des dritten Schaltungsträgers.

Der laterale Wärmeausdehnungskoeffizient eines Schaltungsträgers kann dabei als Änderung einer lateralen Ausdehnung, also als Längen- und/oder Breitenänderung, des jeweiligen Schaltungsträgers bei einer vorgegebenen Temperaturänderung verstanden werden, insbesondere bezogen auf eine vorgegebene Ausgangstemperatur.

Dadurch, dass der laterale Wärmeausdehnungskoeffizient des zweiten Schaltungsträgers größer ist als derjenige des ersten Schaltungsträgers und eine Betriebstemperatur des elektronischen Schaltkreises stets geringer ist als eine Fügetemperatur, bei der die Schaltungsträger über die Verbindungselemente miteinander verbunden werden, wird durch das Abkühlen eine konvexe Wölbung des zweiten Schaltungsträgers hin zu dem Kühlkörper erzielt. Dementsprechend ist ein thermischer Kontakt des zweiten Schaltungsträgers in einem zentralen Bereich des zweiten Schaltungsträgers zu dem Kühlkörper am besten und verbessert sich bei erhöhter Betriebstemperatur zusätzlich, da die konvexe Wölbung bis zur Fügetemperatur abnimmt.

Dies entspricht einer optimalen thermischen Anbindung. Gemäß einem weiteren unabhängigen Aspekt des verbesserten Konzepts wird ein Stromrichter angegeben, der einen elektronischen Schaltkreis nach dem verbesserten Konzept aufweist.

Der elektronische Schaltkreis ist dabei insbesondere derart ausgestaltet, dass das erste und das zweite Halbleiterbauelement mittels des ersten Schaltungsträgers zu einer Halbbrückenschaltung oder zu einem Teil einer sonstigen Brückenschaltung verschaltet sind.

Unter einem Stromrichter (englisch "power converter") kann eine Vorrichtung zur Umwandlung elektrischer Energie einer ersten Art in elektrische Energie einer zweiten Art verstanden werden.

Der Stromrichter kann insbesondere als Umrichter, Wechselrichter, insbesondere Multilevel-Wechselrichter, Gleichrichter oder als Gleichspannungswandler ausgestaltet sein.

Unter einem Umrichter kann dabei ein Stromrichter verstanden werden, der eine erste Wechselspannung in eine zweite Wechselspannung, insbesondere mit einer anderen Frequenz und/oder Phasenlage, umwandelt. Unter einem Wechselrichter kann ein Stromrichter verstanden werden, der eine Gleichspannung in eine Wechselspannung umwandelt. Unter einem Gleichrichter kann ein Stromrichter verstanden werden, der eine Wechselspannung in eine Gleichspannung umwandelt. Unter einem Gleichspannungswandler kann ein Stromrichter verstanden werden, der eine erste Gleichspannung in eine zweite Gleichspannung umwandelt.

Gemäß zumindest einer Ausführungsform weist der Stromrichter einen gemeinsamen Schaltungsträger auf sowie zwei oder mehr elektronische Schaltkreise, wobei jeder der elektronischen Schaltkreise nach dem verbesserten Konzept ausgestaltet ist. Dabei bildet der gemeinsame Schaltungsträger für jeden der elektronischen Schaltkreise den entsprechenden ersten Schaltungsträger. Mit anderen Worten ist der erste Schaltungsträger jedes der elektronischen Schaltkreise durch den gemeinsamen Schaltungsträger des Stromrichters gegeben.

Durch einen Stromrichter nach dem verbesserten Konzept kann also auf Bonddrähte oder sonstige Draht- oder Steckverbindungen verzichtet werden. Insbesondere ist es nicht erforderlich, Powermodule zum Aufbau des Stromrichters vorzusehen. Die entsprechenden Vorteile ergeben sich aus den oben beschriebenen Vorteilen eines elektronischen Schaltkreises nach dem verbesserten Konzept.

Gemäß zumindest einer Ausführungsform des Stromrichters sind die elektronischen Schaltkreise jeweils derart ausgestaltet, dass sie einen jeweiligen Kühlkörper aufweisen, auf dem der zweite und gegebenenfalls der dritte Schaltungsträger angeordnet ist.

Gemäß zumindest einer Ausführungsform weist der Stromrichter einen gemeinsamen Kühlkörper auf. Der gemeinsame Kühlkörper bildet dabei für jeden der elektronischen Schaltkreise den entsprechenden Kühlkörper. Mit anderen Worten ist der Kühlkörper jedes der elektronischen Schaltkreise durch den gemeinsamen Kühlkörper des Stromrichters gegeben.

Gemäß zumindest einer Ausführungsform weist der Stromrichter eine gemeinsame Klemmvorrichtung oder mehrere Klemmvorrichtungen auf. Die gemeinsame Klemmvorrichtung bildet dabei für jeden der elektronischen Schaltkreise eine jeweilige Klemmvorrichtung wie oben beschrieben oder die mehreren Klemmvorrichtungen bilden die jeweiligen Klemmvorrichtungen der elektronischen Schaltkreise.

Gemäß einem weiteren unabhängigen Aspekt des verbesserten Konzepts wird ein Verfahren zur Herstellung eines elektronischen Schaltkreises, insbesondere eines elektronischen Schaltkreises nach dem verbesserten Konzept, angegeben. Dabei werden ein erster und ein zweiter Schaltungsträger bereitgestellt. Ein leistungselektronisches erstes Halbleiterbauelement wird mittels Chipbonden auf dem zweiten Schaltungsträger befestigt. Ein erstes Verbindungselement wird auf den ersten Schaltungsträger oder auf den zweiten Schaltungsträger aufgebracht. Das erste Verbindungselement wird stoffschlüssig mit dem ersten Schaltungsträger und dem zweiten Schaltungsträger verbunden, derart, dass das erste Verbindungselement über eine zweite Durchkontaktierung des ersten Schaltungsträgers mit einer zweiten Leiterbahn des ersten Schaltungsträgers elektrisch verbunden wird. Das erste Halbleiterbauelement und ein zweites Halbleiterbauelement werden auf dem ersten Schaltungsträger mittels Chipbonden derart befestigt, dass eine Oberseite des ersten Halbleiterbauelements über eine erste Durchkontaktierung des ersten Schaltungsträgers mit einer ersten Leiterbahn des ersten Schaltungsträgers verbunden wird und eine Oberseite des zweiten Halbleiterbauelements elektrisch mit der zweiten Leiterbahn verbunden wird.

Mögliche Reihenfolgen der Schritte des Verfahrens sind für den Fachmann ersichtlich. Insbesondere sind die Schritte des Verfahrens nicht notwendigerweise in der Reihenfolge auszuführen, in der sie hier beschrieben sind.

Gemäß zumindest einer Ausführungsform des Verfahrens zur Herstellung des elektronischen Schaltkreises wird das zweite Halbleiterbauelement derart mittels des Chipbonden auf dem ersten Schaltungsträger befestigt, dass eine Oberseite des zweiten Halbleiterbauelements über eine dritte Durchkontaktierung des ersten Schaltungsträgers mit der zweiten Leiterbahn elektrisch verbunden wird.

Gemäß zumindest einer Ausführungsform wird das zweite Halbleiterbauelement mittels Chipbonden auf einem dritten Schaltungsträger befestigt.

Gemäß zumindest einer Ausführungsform wird ein zweites Verbindungselement auf den ersten oder auf den dritten Schaltungsträger aufgebracht. Das zweite Verbindungselement wird stoffschlüssig mit dem ersten Schaltungsträger und mit dem dritten Schaltungsträger verbunden, derart, dass das zweite Verbindungselement über eine vierte Durchkontaktierung des ersten Schaltungsträgers mit einer dritten Leiterbahn des ersten Schaltungsträgers oder mit der ersten Leiterbahn elektrisch verbunden wird.

Gemäß zumindest einer Ausführungsform wird ein Kühlkörper mechanisch mit dem zweiten Schaltungsträger und gegebenenfalls mit dem dritten Schaltungsträger verbunden.

Insbesondere erfolgt das Verbinden des Kühlkörpers mit dem zweiten und gegebenenfalls dem dritten Schaltungsträger nach dem stoffschlüssigen Verbinden des ersten Verbindungselements mit dem ersten und dem zweiten Schaltungsträger beziehungsweise, falls zutreffend, nach dem stoffschlüssigen Verbinden des zweiten Verbindungselements mit dem ersten Schaltungsträger und dem dritten Schaltungsträger.

Insbesondere kühlen der erste und der zweite Schaltungsträger und, falls zutreffend, der dritte Schaltungsträger zwischen dem stoffschlüssigen Verbinden des oder der Verbindungselemente mit den entsprechenden Schaltungsträgern und dem Verbinden des Kühlkörpers mit den entsprechenden Schaltungsträgern ab.

Dadurch wird eine konvexe Wölbung des zweiten und, falls zutreffend, des dritten Schaltungsträgers hin zu dem Kühlkörper erzielt, was eine thermische Anbindung der Schaltungsträger an den Kühlkörper verbessert.

Weitere Ausgestaltungen des Verfahrens nach dem verbesserten Konzept folgen unmittelbar aus den verschiedenen Ausgestaltungsformen des elektronischen Schaltkreises oder des Stromrichters nach dem verbesserten Konzept und umgekehrt.

Aus den Ausgestaltungsformen des Verfahrens zur Herstellung eines elektronischen Schaltkreises nach dem verbesserten Konzept folgen unmittelbar entsprechende Ausführungsformen eines Verfahrens zur Herstellung eines Stromrichters nach dem verbesserten Konzept.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen
- FIG 1: eine schematische Schnittdarstellung eines Powermoduls;
- FIG 2: eine schematische Schnittdarstellung einer beispielhaften Ausführungsform eines elektronischen Schaltkreises nach dem verbesserten Konzept;
- FIG 3: eine schematische Schnittdarstellung einer weiteren beispielhaften Ausführungsform eines elektronischen Schaltkreises nach dem verbesserten Konzept;
- FIG 4: eine schematische Schnittdarstellung einer weiteren beispielhaften Ausführungsform eines elektronischen Schaltkreises nach dem verbesserten Konzept;
- FIG 5: eine schematische Schnittdarstellung einer weiteren beispielhaften Ausführungsform eines elektronischen Schaltkreises nach dem verbesserten Konzept;
- FIG 6: eine schematische Schnittdarstellung einer weiteren beispielhaften Ausführungsform eines elektronischen Schaltkreises nach dem verbesserten Konzept;
- FIG 7: eine schematische Darstellung einer beispielhaften Ausführungsform eines Verfahrens nach dem verbesserten Konzept;
- FIG 8: eine schematische Darstellung einer beispielhaften Ausführungsform eines Stromrichters nach dem verbesserten Konzept;
- FIG 9: eine alternative Darstellung des Stromrichters der FIG 8; und
- FIG 10: eine schematische Schnittdarstellung einer weiteren beispielhaften Ausführungsform eines elektronischen Schaltkreises nach dem verbesserten Konzept.

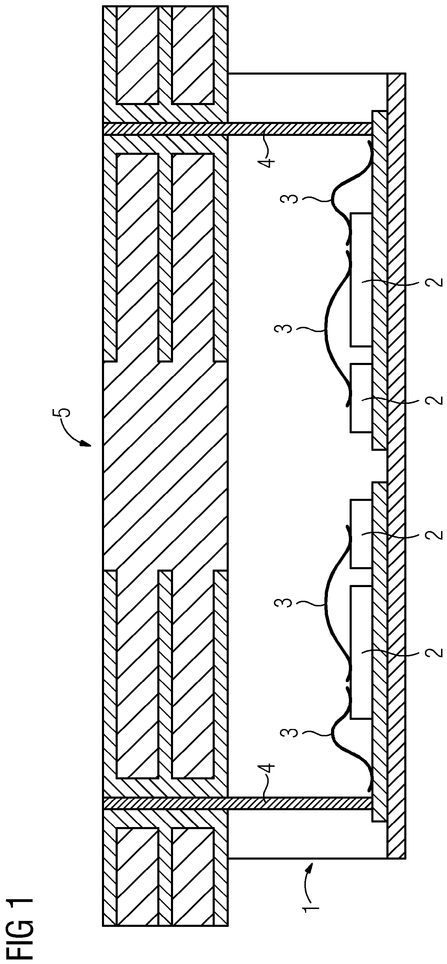

FIG 1 zeigt ein Powermodul 1, bei dem mehrere leistungselektronische Schaltelemente 2 mittels Bonddrähten 3 elektrisch mit metallischen Verbindungselementen 4 verbunden sind. Das Powermodul 1 ist mittels der Verbindungselemente 4 mit einer Leiterplatte 5 verbunden.

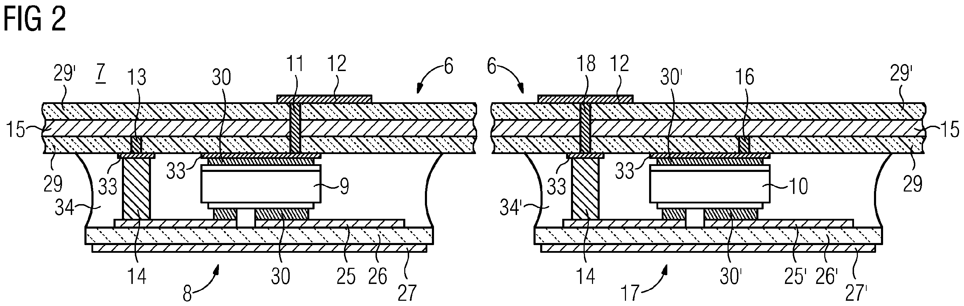

FIG 2 zeigt eine Schnittdarstellung einer beispielhaften Ausführungsform eines elektronischen Schaltkreises 7 nach dem verbesserten Konzept.

Der elektronische Schaltkreis 7 weist einen ersten Schaltungsträger 6 auf, der beispielsweise als mehrlagige Leiterplatte ausgebildet ist. Der Schaltkreis 7 weist außerdem einen zweiten Schaltungsträger 8 und einen dritten Schaltungsträger 17 auf, die beispielsweise jeweils als DCB-Substrat ausgestaltet sind. Die DCB-Substrate weisen beispielsweise eine erste Kupferschicht 25, 25', einen Keramikkörper beziehungsweise eine Keramikschicht 26, 26' und eine zweite Kupferschicht 27, 27' auf. Dabei sind die Keramikschichten 26 26' jeweils zwischen den Kupferschichten 25, 25', 27, 27' angeordnet. In anderen Ausführungen können statt den Kupferschichten 25, 25', 27, 27' andere Metallschichten eingesetzt werden.

Der Schaltkreis 7 weist einen ersten Leistungstransistor 9 auf, der mittels Chipbonden mit der ersten Kupferschicht 25 des zweiten Schaltungsträgers 8 verbunden ist und ebenfalls mittels Chipbonden mit einer Außenlage 33, also einer außenliegenden Leitungsschicht, des ersten Schaltungsträgers 6.

Insbesondere kann sich zwischen dem ersten Leistungstransistor 9 und der ersten Kupferschicht 25 beziehungsweise zwischen dem ersten Leistungstransistor 9 und der Außenlage 33 ein Verbindungsmaterial 30, beispielsweise eine Klebstoffschicht oder ein Lot- oder Sintermaterial, befinden, das zum Chipbonden verwendet wurde.

Der Schaltkreis 7 weist außerdem einen zweiten Leistungstransistor 10 auf, der per Chipbonden und gegebenenfalls unter Verwendung eines entsprechenden Verbindungsmaterials 30' mit dem ersten Schaltungsträger 6, insbesondere der Außenlage 33, sowie der ersten Kupferschicht 25' des dritten Schaltungsträgers 17 verbunden ist.

Die Leistungstransistoren 9, 10 sind hier und im Folgenden stets lediglich beispielhaft gewählt. In anderen Ausführungen können andere leistungselektronische Halbleiterbauelemente an die Stelle eines der Leistungstransistoren 9, 10 oder an die Stelle beider Leistungstransistoren 9, 10 treten.

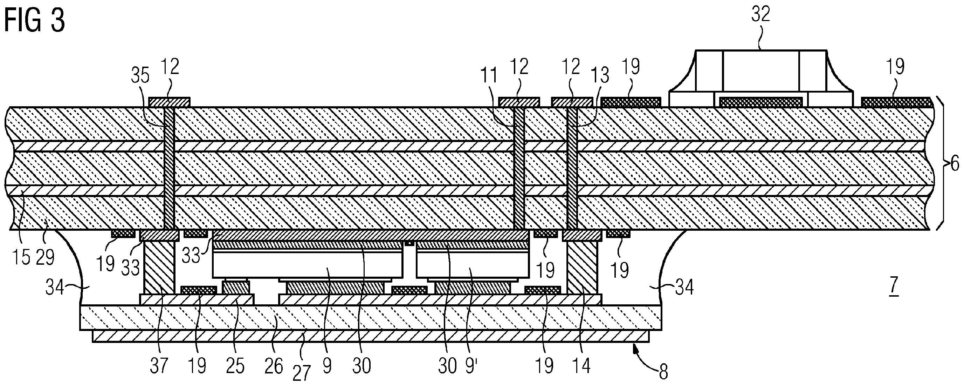

Der Übersichtlichkeit halber sind nur zwei der jeweils drei Anschlüsse der Leistungstransistoren 9, 10 als kontaktiert dargestellt. Es wird diesbezüglich auch auf FIG 3 verwiesen.

Die Leistungstransistoren 9, 10 sind beispielsweise mit ihren jeweiligen Gate-Seiten dem zweiten Schaltungsträger 8 beziehungsweise dem dritten Schaltungsträger 17 zugewandt.

Der Schaltkreis weist ein erstes Verbindungselement 14 und ein zweites Verbindungselement 20 auf. Die Verbindungselemente 14, 20 sind beispielsweise aus einem Lot- oder Sintermaterial gebildet. Die Verbindungselemente 14, 20 stellen jeweils stoffschlüssige Verbindungen zwischen den ersten Kupferschichten 25, 25' und der Außenlage 33 her. Die Verbindungselemente 14, 20 können auch mehrteilig in Form von verschiedenen Schichten oder als Verbund ausgeführt sein.

Der erste Schaltungsträger 6 weist beispielsweise auf einer den Leistungstransistoren 9, 10 abgewandten Seite der Außenlage 33 eine erste Isolierschicht 29 auf. Auf einer der Außenlage 33 abgewandten Seite der Isolierschicht 29 ist beispielsweise eine elektrisch leitfähige Innenlage 15 des Schaltungsträgers 6 angeordnet. Auf einer der Isolierschicht 29 abgewandten Seite der Innenlage 15 ist beispielsweise eine weitere Isolierschicht 29' des ersten Schaltungsträgers 6 angeordnet, und auf einer der Innenlage 15 abgewandten Seite der weiteren Isolierschicht 29' ist eine weitere Außenlage 12 des ersten Schaltungsträgers 6 angeordnet.

Eine erste Durchkontaktierung 11 des ersten Schaltungsträgers 6 führt durch die Isolierschichten 29, 29' und die Innenlage 15 hindurch und verbindet die Außenlage 33 mit der Außenlage 12, insbesondere den ersten Leistungstransistor 9 mit einer Leiterbahn der Außenlage 12.

Eine zweite Durchkontaktierung 13 des ersten Schaltungsträgers 6 führt durch die Isolierschicht 29 hindurch und verbindet die Außenlage 33 mit der Innenlage 15, insbesondere das Verbindungselement 14 mit einer Leiterbahn der Innenlage 15. Eine dritte Durchkontaktierung 16 führt ebenfalls durch die Isolierschicht 29 und verbindet die Außenlage 33, insbesondere den zweiten Leistungstransistor 10, mit der Leiterbahn der Innenlage 15.

Eine vierte Durchkontaktierung 18 führt durch die Isolierschicht 29, die Innenlage 15 sowie die weitere Isolierschicht 29' und verbindet die Außenlage 33 mit der Außenlage 12, insbesondere das zweite Verbindungselement 20 mit der Leiterbahn der weiteren Außenlage 12 oder mit einer weiteren Leiterbahn der weiteren Außenlage 12.

Der Schaltkreis 7 kann ein Vergussmaterial 34 aufweisen, in welchem der erste Leistungstransistor 9 sowie das erste Verbindungselement 14 eingebettet sind und das beispielsweise mit Hilfe eines Underfillers gefertigt ist. Entsprechend kann der Schaltkreis 7 ein weiteres Vergussmaterial 34' beinhalten, in welchem der weitere Leistungstransistor 10 sowie das zweite Verbindungselement 20 eingebettet sind und das beispielsweise ebenfalls mit Hilfe eines Underfillers gefertigt sein kann.

Eine Isolation des zweiten und dritten Schaltungsträgers 8, 17 kann beispielsweise allseitig die entsprechenden Leitstrukturen und insbesondere die die Halbleiterchips tragende Struktur umlaufend überlappen, beispielsweise um 0,5 mm oder mehr.

FIG 2 zeigt eine Reihenschaltung der Leistungstransistoren 9, 10. In alternativen Ausführungen können die Leistungstransistoren 9, 10 oder entsprechende andere leistungselektronische Bauelemente parallel geschaltet sein.

In FIG 3 ist eine weitere Schnittdarstellung einer weiteren beispielhaften Ausführungsform eines elektronischen Schaltkreises 7 nach dem verbesserten Konzept dargestellt. Der Schaltkreis 7 aus FIG 3 ist demjenigen der FIG 2 ähnlich, so dass hier nur auf die Unterschiede näher eingegangen wird. Der Übersichtlichkeit halber sind der dritte Schaltungsträger 17, der zweite Leistungstransistor 10, das zweite Verbindungselement 20 sowie die entsprechenden Durchkontaktierungen 16, 18 in FIG 3 nicht gezeigt.

Der Schaltkreis 7 der FIG 3 weist eine Diode 9' auf, die insbesondere mit dem ersten Leistungstransistor 9 antiparallel geschaltet ist.

Im Schaltkreis 7 der FIG 3 sind die Durchkontaktierungen 11, 13 beide mit jeweiligen Leiterbahnen auf der weiteren Außenlage 12 verbunden. Darüber hinaus weist der Schaltkreis 7 ein drittes Verbindungselement 37 auf, welches die erste Kupferschicht 25 über eine fünfte Durchkontaktierung 35 mit der weiteren Außenlage 12 verbindet. Bezüglich des dritten Verbindungselements 37 gelten die obigen Ausführungen zu dem ersten Verbindungselement 14 analog. Über das dritte Verbindungselement 37 und die fünfte Durchkontaktierung 35 ist nun auch die dritte Kontaktierung des Leistungstransistors 9 gezeigt. Eine entsprechende Kontaktierung kann auch in dem Schaltkreis 7 der FIG 2 vorgesehen sein.

Die Durchkontaktierungen 11, 13 und 35 können insbesondere auf unterschiedlichen oder gleichen Außen- beziehungsweise Innenlagen geführt sein.

Außerdem weist der Schaltkreis 7 ein weiteres elektronisches Bauelement 32 auf, welches beispielsweise als oberflächenmontiertes Bauelement ausgeführt sein kann und insbesondere auf der dem Leistungstransistor 9 abgewandten Seite des ersten Schaltungsträgers 6 angeordnet sein kann, beispielsweise elektrisch verbunden mit der Außenlage 12.

Im Schaltkreis 7 der FIG 3 sind auch an verschiedenen Stellen Lötstopplackstrukturen 19 dargestellt. Diese können beispielsweise zur Positionierung des Leistungstransistors 9, der Diode 9' und/oder des elektronischen Bauelements 32 dienen und/oder zur Vermeidung einer unkontrollierten Benetzung oder Verteilung von Lotpaste.

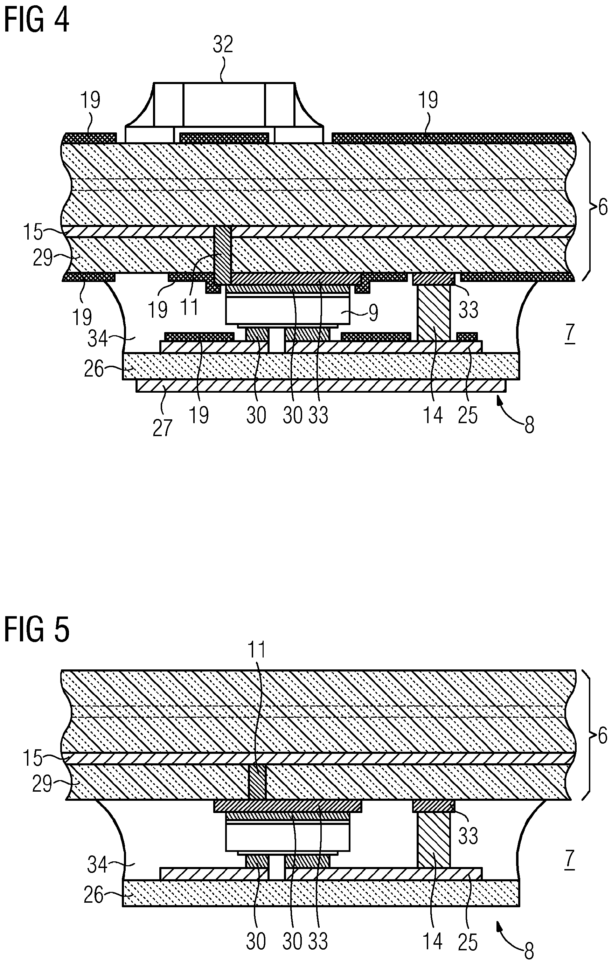

In FIG 4 ist eine Schnittdarstellung einer weiteren beispielhaften Ausführungsform des Schaltkreises 7 nach dem verbesserten Konzept dargestellt. Die Ausführungsform basiert auf denjenigen der FIG 2 und FIG 3, so dass nur auf die Unterschiede näher eingegangen wird. Auch hier sind der Übersichtlichkeit halber der dritte Schaltungsträger 17 sowie der zweite Leistungstransistor 10 und so weiter nicht dargestellt. Wie auch in FIG 2 ist die Kontaktierung des dritten Kontaktierungselements des Leistungstransistors 9 in FIG 4 der Übersichtlichkeit halber nicht dargestellt.

Im Unterschied zu FIG 2 verbindet in FIG 4 die erste Durchkontaktierung 11 den Leistungstransistor 9 mit der Innenlage 15.

In FIG 5 ist eine weitere Schnittdarstellung einer weiteren beispielhaften Ausführungsform eines elektronischen Schaltkreises 7 nach dem verbesserten Konzept gezeigt. Der Schaltkreis 7 der FIG 5 basiert auf demjenigen der FIG 4.

Im Unterschied zu FIG 2, FIG 3 und FIG 4 ist der zweite Schaltungsträger 8 in FIG 5 mit nur einer Kupferschicht 25 ausgeführt. Insbesondere weist der zweite Schaltungsträger 8 hier nur die erste Kupferschicht 25 sowie die Keramikschicht 26 auf, nicht jedoch die zweite Kupferschicht 27.

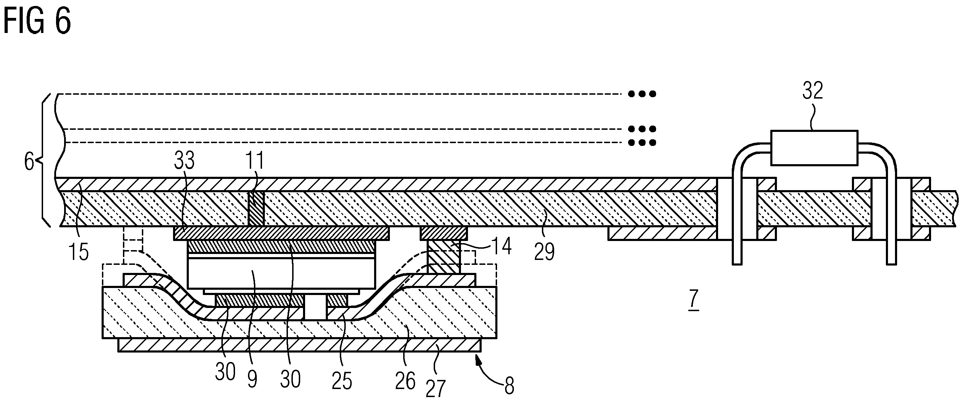

In FIG 6 ist eine Schnittdarstellung durch eine weitere beispielhafte Ausführungsform eines elektronischen Schaltkreises 7 nach dem verbesserten Konzept gezeigt. Die Ausführungsform der FIG 6 basiert auf derjenigen der FIG 4.

Im Unterschied zur FIG 4 ist das weitere elektronische Bauelement 32 als Bauelement zur Durchsteckmontage ausgebildet.

Zudem ist der zweite Schaltungsträger 8 im Vergleich zur FIG 4 modifiziert. Während in FIG 4 die Kupferschichten 25, 27 und Keramikschicht 26 jeweils parallel zueinander ausgerichtete ebene Schichten sind, ist dies in FIG 6 nicht der Fall. Die zweite Kupferschicht 27 ist im Vergleich zur FIG 4 unverändert. Die Keramikschicht 26 weist jedoch in der Seitendarstellung ein eingebuchtetes oder topfförmiges Profil auf. Die Kupferschicht 25 ist mit näherungsweise homogener Dicke ausgeformt, so dass sie sich dem Profil der Keramikschicht 26 anpasst und ebenfalls ein eingebuchtetes oder topfförmiges Profil aufweist.

Dadurch wird eine Kavität geformt, innerhalb welcher der erste Leistungstransistor 9 wenigstens teilweise angeordnet ist. Folglich sind die Abstände zwischen der ersten Kupferschicht 25 und dem ersten Schaltungsträger 6 kleiner als in der Ausführungsform der FIG 4, unter der Annahme identischer Leistungstransistoren 9. Dementsprechend kann die Ausdehnung des Verbindungselements 14, insbesondere eine Höhe des Verbindungselements 14, die erforderlich ist, um den Abstand zwischen der Kupferschicht 25 und der Außenlage 33 zu überbrücken, geringer ausfallen, was fertigungstechnische Vorteile bieten kann. Bei entsprechender Ausgestaltung des topfförmigen Profils kann beispielsweise das Verbindungsmaterial 30 zwischen der Außenlage 33 und dem Leistungstransistor 9 in einem Verfahrensschritt gleichzeitig mit dem Verbindungselement 14 hergestellt werden, insbesondere wenn die entsprechenden Schichtdicken gleich gewählt werden können.

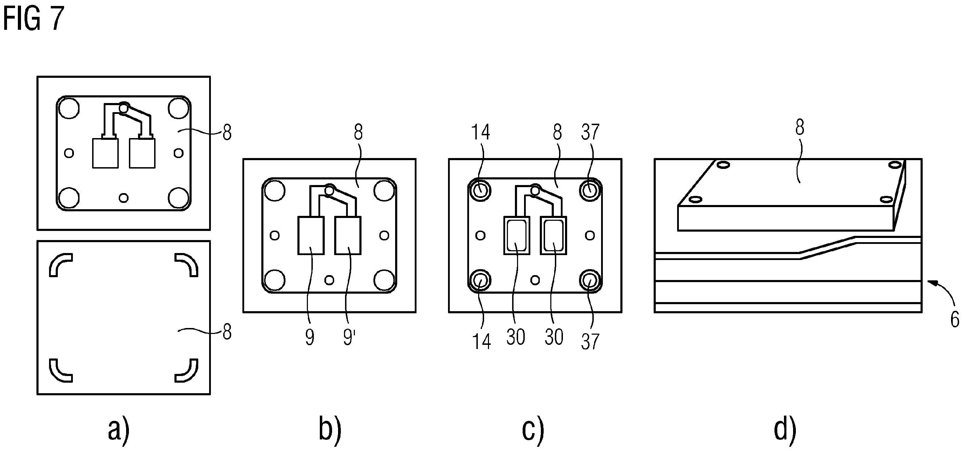

In FIG 7 ist schematisch ein Ablaufdiagramm eines Verfahrens zur Herstellung eines elektronischen Schaltkreises nach dem verbesserten Konzept dargestellt.

In Schritt a) des Verfahrens werden der erste Schaltungsträger 6 sowie der zweite Schaltungsträger 8 bereitgestellt. In Schritt b) werden beispielsweise der Leistungstransistor 9 sowie ein weiteres Halbleiterbauelement 9' dem zweiten Schaltungsträger 8 mittels Chipbonden befestigt. In Schritt c) werden die Verbindungselemente 14, 37 in Form eines Lotmaterials oder einer Lotpaste auf den zweiten Schaltungsträger 8 aufgebracht sowie das Verbindungsmaterial 30 zur Kontaktierung des ersten Leistungstransistors 9 sowie des Halbleiterbauelements 9'. Beispielsweise ist das Material für die Verbindungselemente 14, 37 identisch mit dem Verbindungmaterial 30 auf den Halbleiterbauelementen 9 und 9'. In Schritt d) werden die Verbindungselemente 14, 37 stoffschlüssig mit dem ersten Schaltungsträger 6 verbunden, und das Halbleiterbauelement 9' sowie der Leistungstransistor 9 werden mittels des Verbindungsmaterials 30 ebenfalls mit dem ersten Schaltungsträger 6 verbunden. Analog wird auch mit dem dritten Schaltungsträger 17 und dem zweiten Leistungstransistor 10 verfahren.

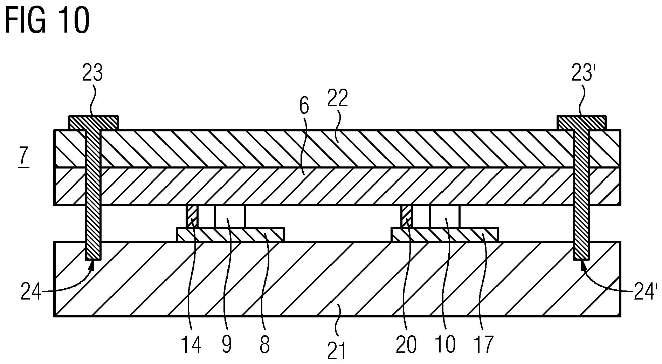

In FIG 10 ist eine weitere Schnittdarstellung durch eine weitere beispielhafte Ausführungsform eines Schaltkreises 7 nach dem verbesserten Konzept dargestellt.

Die Ausführungsform der FIG 10 basiert auf derjenigen der FIG 2, so dass lediglich auf die Unterschiede näher eingegangen wird.

Der Schaltkreis 7 in FIG 10 weist eine Klemmplatte 22 sowie einen gemeinsamen Kühlkörper 21 auf. Der zweite und der dritte Schaltungsträger 8, 17 sind auf dem Kühlkörper 21 angeordnet, und die Klemmplatte 22 liegt direkt oder indirekt, beispielsweise isoliert, auf dem ersten Schaltungsträger 6 auf. Der Kühlkörper 21 weist Bohrungen 24, 24' mit Innengewinden auf, die mit Durchgangsöffnungen durch den ersten Schaltungsträger 6 und durch die Klemmplatte 22 fluchtend angeordnet sind. Mittels Schrauben 23, 23', die durch die Durchgangsöffnungen sowohl der Klemmplatte 22 als auch des ersten Schaltungsträgers 6 geführt sind und die in die Bohrungen 24, 24' eingreifen, sind der erste Schaltungsträger 6, der zweite und dritte Schaltungsträger 8, 17 sowie entsprechend die Leistungstransistoren 9, 10 zwischen dem Kühlkörper 21 und die Klemmplatte 22 eingeklemmt oder gepresst. Dadurch wird eine besonders gute thermische und mechanische Kontaktierung erzielt.

Alternativ kann die Klemmplatte 22 anstelle der zwei Bohrungen 24, 24' und der zwei Schrauben 23, 23' nur eine Bohrung und eine Schraube enthalten, die in ein entsprechendes Gewinde des Kühlkörpers 21 greift.

Die Klemmplatte 22 lässt sich alternativ auch mit einem Spreizelement anstelle der Schraube oder der Schrauben befestigen, wobei das Spreizelement in eine Hinterschneidung in dem Kühlkörper 21 greift.

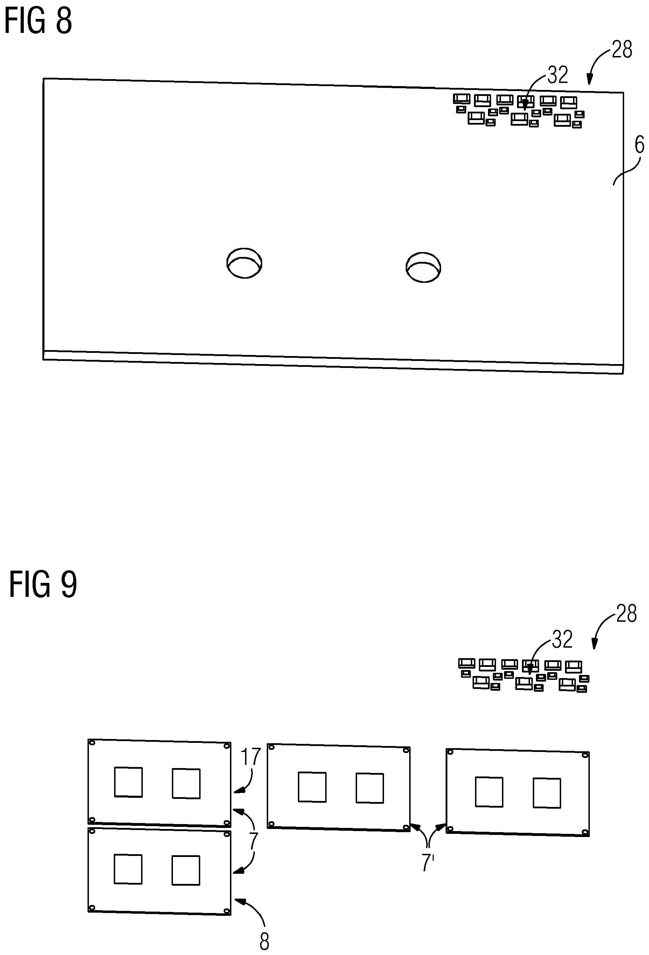

In FIG 8 ist eine schematische Darstellung einer beispielhaften Ausführungsform eines Teils eines Stromrichters 28, beispielsweise eines Umrichters, nach dem verbesserten Konzept gezeigt. In FIG 9 ist derselbe Teil des Stromrichters 28 gezeigt, wobei der erste Schaltungsträger 6 nicht dargestellt ist.

Auf einer Seite des ersten Schaltungsträgers 6 sind ein elektronischer Schaltkreis 7 sowie ein weiterer elektronischer Schaltkreis 7' angeordnet, die jeweils nach dem verbesserten Konzept ausgeführt ist. Auf der gegenüberliegenden Seite des ersten Schaltungsträgers 6 sind verschiedene elektronische Bauelemente 32 angeordnet.

Die Schaltkreise 7 und 7' müssen nicht zwangsläufig getrennt ausgestaltet sein. Sie können in alternativen Ausführungsformen auch teilweise parallel geschaltet sein, zum Beispiel bei Verwendung desselben Zwischenkreises über die DC-Anschlüsse und verschiedenen Phasenabgänge (AC-Anschlüsse).

Wie in den FIG 8 und FIG 9 gezeigt, kommt ein Stromrichter 28 nach dem verbesserten Konzept ohne Powermodule aus.

Mit dem verbesserten Konzept wird ein flexibler Ansatz zum Bereitstellen eines elektronischen Schaltkreises mit leistungselektronischen Bauelementen sowie eines Stromrichters angegeben, der es erlaubt, durch den Verzicht auf Bonddrähte ein besonders niederinduktives Gesamtsystem zu erzielen. Durch den direkten Aufbau des zweiten und des dritten Schaltungsträgers auf den ersten Schaltungsträger, beispielsweise in einem SMT-Prozess, wird eine modullose, quasi ideale Integration möglich und damit eine günstige Möglichkeit angegeben, die elektrische Performance schnell schaltender Leistungshalbleiter voll auszunutzen.

Neben der elektrischen Verbindung der einzelnen Schaltungsträger untereinander können die flächigen Verbindungselemente auch eine thermisch gute Leitfähigkeit aufweisen, so dass ein Wärmeabtransport oder eine Pufferwirkung durch die erhöhte Wärmekapazität von den Leistungshalbleitern beziehungsweise von den Verbindungselementen weg weiter verbessert wird.

Das verbesserte Konzept erlaubt es insbesondere einem Hersteller von Stromrichtern ohne die für den klassischen Leistungsmodulaufbau erforderlichen Spezialtechnologien, wie beispielsweise Drahtbonden, zu verwenden, und eine planare Aufbautechnik zu realisieren.

## Patentansprüche

1. Elektronischer Schaltkreis aufweisend
einen ersten und einen zweiten Schaltungsträger (6, 8);
ein leistungselektronisches erstes Halbleiterbauelement (9) mit einer Oberseite, die an einer Unterseite des ersten Schaltungsträgers (6) anliegt, sowie einer Unterseite, die an einer Oberseite des zweiten Schaltungsträgers (8) anliegt;
und ein zweites Halbleiterbauelement (10);
**dadurch gekennzeichnet, dass** der erste Schaltungsträger (6) eine erste Durchkontaktierung (11) aufweist, welche die Oberseite des ersten Halbleiterbauelements (9) elektrisch mit einer ersten Leiterbahn des ersten Schaltungsträgers (6) verbindet;
der erste Schaltungsträger (6) eine zweite Durchkontaktierung (13) aufweist, welche ein zwischen der Unterseite des ersten Schaltungsträgers (6) und der Oberseite des zweiten Schaltungsträgers (8) angeordnetes erstes Verbindungselement (14) mit einer zweiten Leiterbahn des ersten Schaltungsträgers (6) elektrisch verbindet;
über das erste Verbindungselement (14) eine stoffschlüssige Verbindung zwischen der Oberseite des zweiten Schaltungsträgers (8) und der Unterseite des ersten Schaltungsträgers (6) hergestellt wird;
eine Oberseite des zweiten Halbleiterbauelements (10) an der Unterseite des ersten Schaltungsträgers (6) anliegt und elektrisch mit der ersten Leiterbahn oder mit der zweiten Leiterbahn verbunden ist.

2. Elektronischer Schaltkreis nach Anspruch 1,
**dadurch gekennzeichnet, dass** der erste Schaltungsträger (6) eine dritte Durchkontaktierung (16) aufweist, welche die Oberseite des zweiten Halbleiterbauelements (10) elektrisch mit der zweiten Leiterbahn verbindet.

3. Elektronischer Schaltkreis nach einem der Ansprüche 1 oder 2,
**dadurch gekennzeichnet, dass** der Schaltkreis (7) einen dritten Schaltungsträger (17) aufweist; und
eine Unterseite des zweiten Halbleiterbauelements (10) an einer Oberseite des dritten Schaltungsträgers (17) anliegt.

4. Elektronischer Schaltkreis nach Anspruch 3,
**dadurch gekennzeichnet, dass** der erste Schaltungsträger (6) eine vierte Durchkontaktierung (18) aufweist, welche ein zwischen der Unterseite des ersten Schaltungsträgers (6) und der Oberseite des dritten Schaltungsträgers (17) angeordnetes zweites Verbindungselement (20) mit der ersten Leiterbahn oder einer dritten Leiterbahn des ersten Schaltungsträgers (6) elektrisch verbindet; und
über das zweite Verbindungselement (20) eine stoffschlüssige Verbindung zwischen der Oberseite des dritten Schaltungsträgers (17) und der Unterseite des ersten Schaltungsträgers (6) hergestellt wird.

5. Elektronischer Schaltkreis nach einem der Ansprüche 1 bis 4,
**dadurch gekennzeichnet, dass** der Schaltkreis (7) einen Kühlkörper (21) aufweist, auf dem der zweite Schaltungsträger (8) angeordnet ist.

6. Elektronischer Schaltkreis nach Anspruch 5,
**dadurch gekennzeichnet, dass** der Schaltkreis (7) eine Klemmvorrichtung (22, 23, 23') aufweist, um den zweiten Schaltungsträger (8) über eine Krafteinwirkung auf den ersten Schaltungsträger (6) auf den Kühlkörper (21) zu pressen.

7. Elektronischer Schaltkreis nach einem der Ansprüche 1 bis 6,
**dadurch gekennzeichnet, dass** das erste Halbleiterbauelement (9) und/oder das zweite Halbleiterbauelement (10) als leistungselektronische Schaltelemente ausgestaltet sind.

8. Elektronischer Schaltkreis nach einem der Ansprüche 1 bis 7,
**dadurch gekennzeichnet, dass** das erste und das zweite Halbleiterbauelement (9, 10) mittels des ersten Schaltungsträgers (6) zu einer Halbbrückenschaltung oder zu einem Teil einer sonstigen Brückenschaltung verschaltet sind.

9. Elektronischer Schaltkreis nach einem der Ansprüche 1 bis 8,
**dadurch gekennzeichnet, dass** der zweite Schaltungsträger (8) eine die Oberseite des zweiten Schaltungsträgers (8) bildende erste elektrisch leitfähige Schicht (25) und eine, auf einer dem ersten Schaltungsträger (6) abgewandten Seite der ersten elektrisch leitfähigen Schicht (25) angeordnete, elektrisch isolierende Schicht (26) aufweist.

10. Elektronischer Schaltkreis Anspruch 9,
**dadurch gekennzeichnet, dass** der zweite Schaltungsträger (8) eine, auf einer der ersten elektrisch leitfähigen Schicht (25) abgewandten Seite der elektrisch isolierenden Schicht (26) angeordnete, zweite elektrisch leitfähige Schicht (27) aufweist.

11. Elektronischer Schaltkreis nach einem der Ansprüche 1 bis 10,
**dadurch gekennzeichnet, dass** ein lateraler Wärmeausdehnungskoeffizient des ersten Schaltungsträgers (6) größer oder gleich einem lateralen Wärmeausdehnungskoeffizient des zweiten Schaltungsträgers (8) ist.

12. Stromrichter, aufweisend einen elektronischen Schaltkreis (7) nach einem der Ansprüche 1 bis 11.

13. Stromrichter nach Anspruch 12,
**dadurch gekennzeichnet, dass** der Stromrichter (28) einen gemeinsamen Schaltungsträger (6) aufweist;
der Stromrichter (28) zwei oder mehr elektronische Schaltkreise (7, 7') aufweist, die jeweils nach einem der Ansprüche 1 bis 11 ausgestaltet sind;
der gemeinsame Schaltungsträger (6) für jeden der elektronischen Schaltkreise (7, 7') den entsprechenden ersten Schaltungsträger (6) bildet.

14. Stromrichter nach Anspruch 13,
**dadurch gekennzeichnet, dass** der Stromrichter (28) einen gemeinsamen Kühlkörper (21) aufweist;
die elektronischen Schaltkreise (7, 7') jeweils gemäß Anspruch 5 ausgestaltet sind; und
der gemeinsame Kühlkörper (21) für jeden der elektronischen Schaltkreise (7, 7') den entsprechenden Kühlkörper (21) bildet.

15. Verfahren zur Herstellung eines elektronischen Schaltkreises (7), welches folgende Schritte beinhaltet:
Bereitstellen eines ersten und eines zweiten Schaltungsträgers (6, 8);
Befestigen eines leistungselektronischen ersten Halbleiterbauelements (6) mittels Chipbonden auf dem zweiten Schaltungsträger (8);
Aufbringen eines ersten Verbindungselements (14) auf den ersten Schaltungsträger (6) oder auf den zweiten Schaltungsträger (8);
stoffschlüssiges Verbinden des ersten Verbindungselements (14) mit dem ersten Schaltungsträger (6) und dem zweiten Schaltungsträger (8), derart, dass das erste Verbindungselement (14) über eine zweite Durchkontaktierung (13) des ersten Schaltungsträgers (6) mit einer zweiten Leiterbahn des ersten Schaltungsträgers (6) elektrisch verbunden wird; und
Befestigen des ersten Halbleiterbauelements (9) und eines zweiten Halbleiterbauelements (10) auf dem ersten Schaltungsträger (6) mittels Chipbonden, derart, dass eine Oberseite des ersten Halbleiterbauelements (9) über eine erste Durchkontaktierung (11) des ersten Schaltungsträgers (6) mit einer ersten Leiterbahn des ersten Schaltungsträgers (6) verbunden wird und eine Oberseite des zweiten Halbleiterbauelements (10) elektrisch mit der zweiten Leiterbahn verbunden wird.
